# EUROPÄISCHE PATENTSCHRIFT

(11) **EP 0 379 625 B1**
(45) Veröffentlichungstag und Bekanntmachung des Hinweises auf die Patenterteilung: **19.07.1995**
(21) Anmeldenummer: 89101434.2
(22) Anmeldetag: 27.01.1989
(51) Int. Cl.: H03M 13/00, G06F 11/10

(54) **Verfahren zur Behandlung von paritätsüberwachbaren Binärcodeworten, die im Zuge ihrer Übertragung eine digitale Dämpfung und/oder Codekonvertierung erfahren**
Method for the treatment of parity-controllable binary code words which undergo a digital damping and/or code conversion during their transmission
Procédé de traitement de mots binaires contrôlables par parité, qui, pendant leur transmission, subissent une atténuation numérique et/ou une conversion de code

(43) Veröffentlichungstag der Anmeldung: 01.08.1990
(73) Patentinhaber: SIEMENS AKTIENGESELLSCHAFT, 80333 München (DE)
(72) Erfinder: Böcker, Gerd, Dipl.-Ing., D-8000 München 71 (DE); Kaderka, Rostislav, Dipl.-Ing., D-8034 Germering (DE); Krumenacker, Rudolf, Dipl.-Ing., D-8000 München 211 (DE)

(56) Entgegenhaltungen:
- EP-A- 0 267 499
- US-A- 4 155 070

## Beschreibung

Die Erfindung betrifft ein Verfahren zur Behandlung von paritätsüberwachbaren Binärcodeworten, die im Zuge ihrer Übertragung eine digitale Dämpfung und/oder Codekonvertierung erfahren. Einrichtungen zur Codekonvertierung von Binärworten, die von einem Paritätsbit begleitet sind, werden zum Beispiel in US-A-4 155 070 und EP-A- 0 267 499 beschrieben.

Ein solches Verfahren kommt beispielsweise in Betracht im Zusammenhang mit der Übertragung von Sprach-/Dateninformationen in peripheren Anschlußgruppen digitaler Vermittlungssysteme, bei denen die die Sprach- und Dateninformationen darstellenden Binärcodeworte von einem Paritätsbit begleitet sind, und die, insbesondere wenn sie im Zusammenhang mit Konferenzverbindungen stehen, eine Schaltungsanordnung zur Erzeugung einer digitalen Dämpfung durchlaufen, die gegebenenfalls auch noch eine Codekonvertierung von einer dem A-Gesetz entsprechenden Codedarstellung in eine dem »-Gesetz entsprechende Codedarstellung und umgekehrt bewirkt. Durch die letztgenannte Maßnahme erfolgt eine Anpassung des Vermittlungssystems an die jeweilige länderspezifische Codierung, die in dem Fernmeldenetz vorgesehen ist, in dem dieses Vermittlungssystem eingesetzt ist.

Die Erzeugung einer digitalen Dämpfung bzw. einer Codekonvertierung kann zur Folge haben, daß die die Einrichtung zur Erzeugung einer solchen Dämpfung und/oder Codekonvertierung verlassenden Codeworte eine andere Parität aufweisen als die entsprechenden Codeworte vor einer solchen Behandlung, weswegen für die weiterzuübertragenden, einer Dämpfung und/oder Konvertierung unterzogenen Codeworte erneut ein Paritätsbit gebildet werden muß. Das bedeutet aber ferner, daß unter Umständen Paritätsfehler, die die ankommenden Codeworte aufweisen, bei einer Codeüberwachung, die an einer zentralen Stelle vorgenommen wird, nicht erkannt werden können.

Die Aufgabe der Erfindung besteht daher darin, ein Verfahren zur Behandlung paritätsüberwachbarer Binärcodeworte anzugeben, das gewährleistet, daß durch eine Durchführung einer digitalen Dämpfung und/oder Codekonvertierung vorher schon bestehende Paritätsfehler nicht unerkennbar gemacht werden.

Diese Aufgabe wird durch die im Kennzeichen des Patentanspruchs 1 angegebenen Merkmale gelöst.

Durch das erfindungsgemäße Verfahren ist also gewährleistet, daß in solchen Fällen, in denen die Parität schon bei den ankommenden Codeworten falsch ist, bei den nach einer Durchführung dieser Dämpfung und/oder Codekonvertierung zusammen mit den erfindungsgemäß behandelten Paritätsbits übertragenen Codeworten ebenfalls eine falsche Parität vorliegt.

Gemäß weiteren Ausgestaltungen der Erfindung, die in Unteransprüchen gekennzeichnet sind, werden Wege angegeben, wie das dem erfindungsgemäßen Verfahren zugrunde liegende Prinzip zweckmäßig in die Praxis umgesetzt werden kann.

Dabei läßt sich die Lösung gemäß dem Anspruch 4 mit vergleichsweise geringem Hardware-Aufwand realisieren, weist jedoch eine vergleichsweise große Laufzeitverzögerung auf.

Die Realisierung gemäß Anspruch 5 ist demgegenüber bezüglich der Laufzeit günstiger, bedingt jedoch eine größere Verlustleistung.

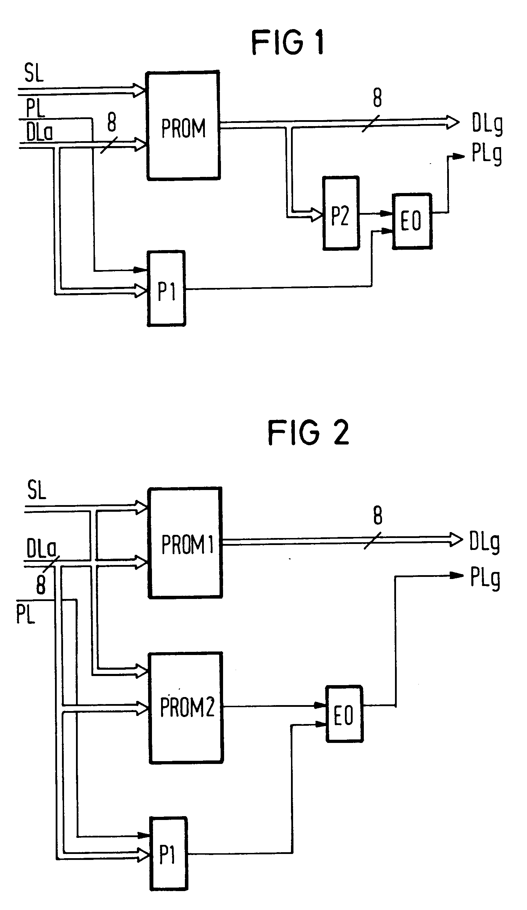

Die Realisierung gemäß den Ansprüchen 6 und 7 stellt die im Hinblick auf den Hardware-Aufwand und die Verlustleistung günstigste Lösung dar und liegt im Hinblick auf die Laufzeitverzögerung zwischen den beiden erstgenannten Lösungen, wobei diese Laufzeitverzögerung immer noch kleiner als eine Taktperiode des schnellsten Systemtaktes eines typischen Vermittlungssystems der eingangs genannten Art ist (8,192 MHz), so daß die Verzögerung in diesem Zusammenhang ohne weiteres hingenommen werden kann. Nachstehend wird die Erfindung anhand von drei Ausführungsbeispielen unter Bezugnahme auf eine Zeichnung näher erläutert. In der Zeichnung zeigen die Figuren 1, 2 und 3 Blockschaltbilder von Anordnungen zur Durchführung der drei Varianten des erfindungsgemäßen Verfahrens.

Die Figur 1 zeigt als wesentlichen Bestandteil einer Einrichtung, mit deren Hilfe eine digitale Dämpfung und/oder eine Codekonvertierung vorgenommen werden kann, einen programmierbaren Lesespeicher PROM. An diesen Speicher ist eingangsseitig eine Datenleitung für ankommende Übertragungsrichtung DLa angeschlossen, auf der hier 8 Bit umfassende Binäcodeworte übertragen werden, die paritätsüberwachbar sind, indem sie jeweils von einem auf einer gesonderten Leitung PL übertragenen Paritätsbit begleitet werden. Ferner ist eingangsseitig ein Steuerleitungsvielfach SL angeschlossen, auf dessen Einzelleitungen Steuerbits angeliefert werden, die die Art der durchzuführenden digitalen Dämpfung und/oder Codekonvertierung festlegen. Die auf den genannten Leitungen DLa und SL ankommenden Bits dienen als Ansteueradressen für den Speicher PROM.

Ausgangsseitig des Speichers ist eine Datenleitung für abgehende Übertragungsrichtung DLg angeschlossen.

Im Lesespeicher PROM sind Codeworte enthalten, die Informationsteile repräsentieren, die gegenüber den entsprechenden auf der Datenleitung DLa ankommenden codierten Informationsteilen in einem Ausmaß gedämpft sind, das durch zugeordnete Steuerbits auf dem Steuerleitungsvielfach SL bestimmt wird. Es sind ferner Codeworte enthalten, die diese gedämpften Informationsteile in einer zweiten Codedarstellung repräsentieren, also beispielsweise in der Codestellung gemäß dem A-Gesetz, wenn die entsprechenden Codeworte gemäß dem »-Gesetz codiert sind und umgekehrt.

Die Durchführung einer digitalen Dämpfung und/oder Codekonvertierung der auf der Datenleitung DLa für ankommende Übertragungsrichtung ankommenden Binärcodeworte erfolgt hier also derart, daß diese Binärcodeworte zusammen mit den die gewünschte Dämpfung und/oder Codekonvertierung angebenden Steuerbits denjenigen Speicherplatz ansteuern, in dem das den gewünschten gedämpften Informationswert in der gewünschten Codedarstellung repräsentierende Codewort gespeichert ist, das daraufhin auf die Übertragungsleitung DLg für abgehende Übertragungsrichtung gelangt.

Bei der Durchführung einer derartigen digitalen Dämpfung und/oder Codekonvertierung kann es natürlich sein, daß die ausgelesenen und weiter übertragenen Codeworte eine andere Parität aufweisen, als dies bei den Codeworten auf der Übertragungsleitung DLa für ankommende Übertragungsrichtung ist, so daß ein eventueller Paritätsfehler der ankommenden Codeworte bei einer später an zentraler Stelle durchgeführten Codeüberwachung nicht mehr erkannt werden kann.

Um zu gewährleisten, daß auch die aus dem Speicher PROM ausgelesenen und zusammen mit einem Paritätsbit übertragenen Daten dann in falscher Parität weitergegeben werden, wenn bei den entsprechenden ankommenden Daten eine falsche Parität festgestellt worden ist, wird beim Ausführungsbeispiel gemäß Figur 1 so vorgegangen, daß die Ergebnisbits der mit Hilfe eines ersten Paritätsgenerators P1 vorgenommenen Paritätsüberwachung der auf der Übertragungsleitung DLa für ankommende Übertragungsrichtung ankommenden Codeworte mit den Paritätsbits, die ein zweiter Paritätsgenerator P2 für die aus dem Speicher PROM ausgelesenen Codeworte bildet, gemäß einer EXCLUSIV-ODER-Funktion verknüpft werden, die dann die für die Weitergabe auf die entsprechende Leitung PLg bestimmten Paritätsbits ergibt. Da unter der Voraussetzung einer angestrebten Parität der 1-Bits der erste Paritätsgenerator P1 bei einer Paritätsüberwachung im Falle einer richtigen Parität immer ein Ergebnisbit des Binärwerts 0, im Falle einer falschen Parität dagegen ein Ergebnisbit des Binärwerts 1 liefert, hat dies zur Folge, daß im Falle einer falschen Parität bei ankommenden Binärcodeworten das Paritätsbit der entsprechenden aus dem Speicher ausgelesenen und weiterzugebenden Binärcodeworte, das durch den Paritätsgenerator P2 gebildet wird, eine Invertierung erfährt, so daß die weiterübertragenen Codeworte zusammen mit dem Paritätsbit eine falsche Parität aufweisen, die dann an zentraler Stelle festgestellt und registriert werden kann.

Da bei der Anordnung gemäß Figur 1 sich drei Durchlaufzeiten, nämlich die des Speichers PROM, die des zweiten Pariätsgenerators P2 und die des EXCLUSIV-ODER-Gliedes EO addieren, handelt es sich hier um eine relativ langsam arbeitende Anordnung.

Die Anordnung gemäß Figur 2 ist diesbezüglich günstiger. Sie weist neben dem programmierbaren Lesespeicher PROM1, der dem programmierbaren Lesespeicher PROM gemäß Figur 1 entspricht, einen zweiten programmierbaren Lesespeicher PROM2 auf, der mit denselben Ansteueradressen beaufschlagt wird wie der erste Speicher PROM1, und in dem die zu den im ersten Speicher enthaltenen Codeworten gehörenden Paritätsbits abgespeichert sind. Es kann daher der zweite Paritätsgenerator P2 gemäß Figur 1 entfallen, es werden vielmehr die aus dem zweiten Speicher PROM2 gleichzeitig mit den im ersten Lesespeicher PROM1 enthaltenen Codeworten ausgelesenen Paritätsbits direkt dem EXCLUSIV-ODER-Glied EO zugeführt, an dessen anderen Eingang die vom ersten Paritätsgenerator P1, der demjenigen gemäß Figur 1 entspricht, gelieferten Ergebnisbits gelangen. Diese Lösung bedingt allerdings gegenüber derjenigen gemäß Figur 1 mehr Baugruppenfläche bei der Schaltungsdurchführung und führt vor allem zu höherer Verlustleistung.

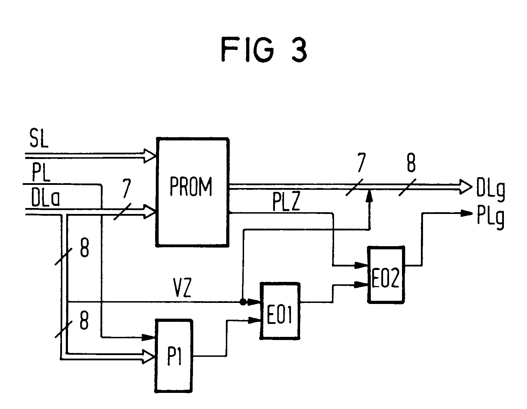

Eine dritte Variante des erfindungsgemäßen Verfahrens, die nachstehend anhand der Figur 3 erläutert wird, läßt sich mit einer Anordnung realisieren, die, sowohl was den Hardware-Aufwand als auch was die Verlustleistung anbetrifft, günstiger ist als die anhand der Figuren 1 und 2 erläuterten Lösungen und die im Hinblick auf die Laufzeitverzögerungen zwischen diesen beiden Lösungen liegt. Da die Laufzeitverzögerung jedoch immer noch kleiner als eine Taktperiode des schnellsten Systemtaktes in einem typischen digitalen Vermittlungssystem als dem bevorzugten Anwendungsfall eines solchen Verfahrens liegt (z.B. 8,192 MHz), ist die letztgenannte Lösung als Optimum anzusehen.

Auch die Anordnung gemäß Figur 3 weist einen programmierbaren Lesespeicher PROM auf, in dem jedoch die den auf der Datenleitung für ankommende Übertragungsrichtung DLa ankommenden Codeworten unter Berücksichtigung einer bestimmten Dämpfung bzw. einer Codekonvertierung entsprechenden Codeworte ohne das höchstwertige, das Vorzeichen bestimmende Bit abgespeichert sind. Als Ansteueradresse des PROM werden von den beispielsweise 8 Bit umfassenden ankommenden Codeworten demnach auch lediglich die 7 niedrigerwertigen Bits herangezogen, zu denen dann noch, wie dargelegt, mehrere Steuerbits kommen, die auf dem Steuerleitungsvielfach SL angeliefert werden. Statt des Vorzeichenbits sind im Lesespeicher PROM die Paritätsbits der dort gespeicherten Codeworte mit abgespeichert, die beim Ausführungsbeispiel gemäß Figur 1 erst nach dem Auslesen mit Hilfe des Paritätsgenerators P2 gebildet werden, bzw. beim Ausführungsbeispiel gemäß Figur 2 im zweiten Lesespeicher PROM2 abgespeichert sind.

Es liegt diesem Konzept die Überlegung zugrunde, daß weder bei der Durchführung einer digitalen Dämpfung noch bei einer Codekonvertierung das Vorzeichenbit eine Änderung erfährt. Es werden die Vorzeichenbits der ankommenden Binärcodeworte daher, wie in der Figur angedeutet, den nur 7 Bits umfassenden aus dem Lesespeicher PROM ausgelesenen Codeworten wieder hinzugefügt.

Mit Hilfe eines Paritätsgenerators P1 wird, wie bei den Ausführungsbeispielen gemäß Figur 1 und 2, die Parität der ankommenden Codeworte überwacht, wobei wieder Paritäten der 1-Bits vorausgesetzt sind, womit gilt, daß bei richtiger Parität ein Ergebnisbit des Binärwerts 0 und bei falscher Parität ein Ergebnisbit des Binärwerts 1 abgegeben wird.

Da das jeweilige Paritätsbit für die im Lesespeicher PROM gespeicherten Codeworte unter der Annahame eines Vorzeichenbits mit dem Binärwert 0 gebildet und ebenfalls im Lesespeicher PROM gespeichert ist, muß unter der genannten Voraussetzung einer Paritätsprüfung auf die Parität der 1-Bits in Fällen, in denen das Vorzeichenbit den Binärwert 1 aufweist, eine Invertierung der Ergebnisbits des Paritätsgenerators P1 vorgenommen werden, was mit Hilfe eines ersten EXCLUSIV-ODER-Gliedes EO1 geschieht, dem die Vorzeichenbits der ankommenden Codeworte auf der Leitung VZ sowie die Ergebnisbits des Paritätsgenerators P1 als Eingangssignale zugeführt werden, und das dann durch seine Ausgangssignale bestimmt, ob die aus dem Lesespeicher PROM ausgelesenen, zur Weiterübertragung bestimmten Paritätsbits invertiert werden oder nicht. Diese Entscheidung geschieht mit Hilfe eines zweiten EXCLUSIV-ODER-Gliedes EO2, dem die genannten Paritätsbits auf der Leitung PLZ sowie die Ausgangssignale des ersten EXCLUSIV-ODER-Gliedes EO1 zugeführt werden, und das dann eine Invertierung der genannten Paritätsbits bewirkt, wenn das EXCLUSIV-ODER-Glied EO1 ein Ausgangssignal mit dem Binärwert 1 abgibt. Die Ausgangssignale des Exclusv-Oder-Gliedes EO2 werden schließlich auf der Leitung PLg zusammen mit den aus dem Lesespeicher PROM ausgelesenen und mit dem entsprechenden Vorzeichenbit vereinigten Codeworten weiterübertragen.

## Patentansprüche

1. Verfahren zur Behandlung von paritätsüberwachbaren Binärcodeworten, die im Zuge ihrer Übertragung eine digitale Dämpfung und/oder Codekonvertierung erfahren,
**dadurch gekennzeichnet**,
daß die Codeworte vor der Durchführung der digitalen Dämpfung und/oder Codekonvertierung einer Paritätsprüfung unterworfen werden, und daß die für die nach der Durchführung der digitalen Dämpfung und/oder Codekonvertierung zur Weiterübertragung bestimmten Codeworte gültigen weiterzuübertragenden Paritätsbits invertiert werden, wenn die genannte Paritätsprüfung das Vorliegen einer falschen Parität ergeben hat.

2. Verfahren nach Anspruch 1, bei dem die Durchführung der digitalen Dämpfung und/oder Codekonvertierung durch Auslesen eines Lesespeichers erfolgt, der mit den ankommenden Codeworten und weiteren Steuerbits als Ansteueradresse angesteuert wird und der den gedämpften Werten und/oder der konvertierten Codedarstellung entsprechende, zur Weiterübertragung bestimmte Codeworte enthält,
**dadurch gekennzeichnet**,
daß die Paritätsbits der für die Weiterübertragung bestimmten Codeworte vor ihrer Weitergabe jeweils mit dem Ergebnisbit der Paritätsprüfung des entsprechenden ankommenden Codewortes verknüpft werden.

3. Verfahren nach Anspruch 2, bei dem Paritätsprüfungen auf eine Parität der 1-Bits vorgenommen werden,
**dadurch gekennzeichnet**,
daß die genannte Verknüpfung eine EXCLUSIV-ODER-Verknüpfung ist.

4. Verfahren nach Anspruch 2 oder 3,
**dadurch gekennzeichnet,**.
daß die Paritätsbits der für die Weiterübertragung bestimmten Codeworte nach dem Auslesen der Codeworte aus dem Lesespeicher (PROM) gebildet werden (Figur 1).

5. Verfahren nach Anspruch 2 oder 3,
**dadurch gekennzeichnet**,
daß die Paritätsbits der für die Weiterübertragung bestimmten Codeworte in einem zweiten, gleichzeitig mit dem ersten Lesespeicher (PROM 1) ausgelesenen Lesespeicher (PROM 2) jeweils unter derselben Adresse wie das zugehörige Codewort gespeichert sind (Figur 2).

6. Verfahren nach Anspruch 2 oder 3,
**dadurch gekennzeichnet**,
daß in den Lesespeicher (PROM) die zur Weiterübertragung bestimmten Codeworte ohne das höchstwertige, ihr Vorzeichen bestimmende Bit abgespeichert sind, als Vorzeichenbit der weiterzuübertragenden Codeworte vielmehr die Vorzeichenbits der entsprechenden ankommenden Codeworte herangezogen werden, daß in dem Lesespeicher stattdessen die für die gespeicherten Teile der weiterzuübertragenden Codeworte gültigen Paritätsbits gespeichert sind, und daß diese Paritätsbits invertiert werden, wenn die Paritätsprüfung der entsprechenden ankommenden Codeworte das Vorliegen einer falschen Parität ergeben hat oder wenn das zu dem betreffenden Codewort gehörende Vorzeichenbit denjenigen Binärwert aufweist, auf dessen Parität geprüft wird.

7. Verfahren nach Anspruch 6, bei dem auf die Parität der 1-Bit geprüft wird,
**dadurch gekennzeichnet,**
daß die Vorzeichenbits der ankommenden Codeworte und die Ergebnisbits der Paritätsprüfung (P1) dieser ankommenden Codeworte gemäß einer EXCLUSIV-ODER-Funktion (EO1) verknüpft werden, und daß die Ergebnisbits dieser Verknüpfungen mit den jeweils entsprechenden für die gespeicherten Teile der weiterzugebenden Codeworte gütigen Paritätsbits ebenfalls gemäß einer EXCLUSIV-ODER-Funktion (EO2) zur Festlegung des Binärwerts der für die Weitergabe bestimmten Paritätsbits verknüpft werden (Figur 3).

## Claims

1. Method for the treatment of parity-controllable binary code words which undergo digital attenuation and/or code conversion during their transmission, characterized in that, before the implementation of digital attenuation and/or code conversion, the code words are subjected to a parity check, and in that the parity bits, which are to be transmitted further and are valid for the code words intended for further transmission after the implementation of digital attenuation and/or code conversion, are inverted if the said parity check has yielded an incorrect parity.

2. Method according to Claim 1, in which the implementation of digital attenuation and/or code conversion takes place by reading out a read-only memory, which is addressed as a selection address by the incoming code words and further control bits and contains code words which correspond to the attenuated values and/or the converted code representation and are intended for further transmission, characterized in that the parity bits of the code words intended for further transmission are each logically combined, prior to their transmission, with the result bit of the parity check of the corresponding incoming code word.

3. Method according to Claim 2, in which parity checks are performed on a parity of the bits having a binary value of 1, characterized in that the said logic combination is an EXCLUSIVE-OR function.

4. Method according to Claim 2 or 3, characterized in that the parity bits of the code words intended for further transmission are formed after reading the code words out of the read-only memory (PROM) (Figure 1).

5. Method according to Claim 2 or 3, characterized in that the parity bits of the code words intended for further transmission are stored, in each case at the same address as the associated code word, in a second read-only memory (PROM 2), which is read out at the same time as the first read-only memory (PROM 1) (Figure 2).

6. Method according to Claim 2 or 3, characterized in that the code words intended for further transmission are stored in the read-only memory (PROM) without their most-significant bit, which determines their sign, rather the sign bits of the corresponding incoming code words are used as the sign bit of the code words to be transmitted further, in that, instead, the parity bits which are valid for the stored parts of the code words to be transmitted further are stored in the read-only memory, and in that these parity bits are inverted if the parity check of the corresponding incoming code words has yielded an incorrect parity or if the sign bit belonging to the code word in question has that binary value whose parity is being checked.

7. Method according to Claim 6, in which the parity of the bits having a binary value of 1 is checked, characterized in that the sign bits of the incoming code words and the result bits of the parity check (P1) of these incoming code words are logically combined in accordance with an EXCLUSIVE-OR function (EO1), and in that, in order to establish the binary value of the parity bits intended for transmission, the result bits of these logic combinations and the respectively corresponding parity bits, which are valid for the stored parts of the code words to be transmitted further, are likewise logically combined in accordance with an EXCLUSIVE-OR function (EO2) (Figure 3).

## Revendications

1. Procédé pour traiter des mots de code binaire, dont la polarité peut être contrôlée et qui, au cours de leur transmission, subissent une atténuation numérique et/ou une conversion de code, caractérisé par le fait
que l'on soumet les mots de code à un contrôle de parité avant d'effectuer l'atténuation numérique et/ou la conversion de code et que l'on inverse les bits de parité, qu'il faut retransmettre et qui sont valables pour les mots de codes destinés à la retransmission, après avoir effectué l'atténuation numérique et/ou la conversion de code, si ledit contrôle de parité a indiqué la présence d'une parité fausse.

2. Procédé suivant la revendication 1, dans lequel on effectue l'atténuation numérique et/ou la conversion de code par lecture d'une mémoire de lecture, que l'on commande lorqu'arrivent les mots de code et d'autres bits de commande en tant qu'adresse de commande et qui contient des mots de code, qui sont destinés à être retransmis, qui correspondent aux valeurs atténuées et/ou à la représentation de code convertie, caractérisé par le fait
que l'on combine avant leur retransmission les bits de parité des mots de codes destinés à être retransmis, chacun avec le bit de résultat du contrôle de parité du mot de code arrivant correspondant.

3. Procédé selon la revendication 2, dans lequel on effectue des contrôles d'une parité des bits 1, caractérisé par le fait que ladite combinaison est une combinaison OU-EXCLUSIF.

4. Procédé selon la revendication 2 ou 3, caractérisé par le fait que l'on forme les bits de parité des mots de code destinés à être retransmis sont formés après la lecture des mots de code à partir de la mémoire de lecture (PROM) (figure 1).

5. Procédé selon la revendication 2 ou 3, caractérisé par le fait que les bits de parité des mots de code destinés à être retransmis sont mémorisés dans une second mémoire de lecture (PROM 2) lue en même temps que la première mémoire de lecture (PROM 1), et ce chacun à la même adresse que le mot de code associé (figure 2).

6. Procédé selon la revendication 2 ou 3, caractérisé par le fait que l'on mémorise les mots de code destinés à être retransmis dans la mémoire de lecture (PROM) sans le bit de poids maximum qui détermine leur signe, et qu'on utilise, au contraire, les bits de signe des mots de code arrivants correspondants, en tant que bits de signe des mots de code à retransmettre, que les bits de parité, qui sont valables pour les parties mémorisées des mots de code à retransmettre, sont mémorisés au lieu de cela dans la mémoire de lecture et on inverse ces bits de parité, lorsque le contrôle de parité des mots de code arrivants correspondants a indiqué la présence d'une parité fausse ou lorsque le bit de signe, qui fait partie du mot de code considéré, a la valeur binaire, dont on contrôle la parité.

7. Procédé selon la revendication 6, dans lequel on contrôle la parité des bits 1, caractérisé par le fait que l'on combine les bits de signe des mots de code arrivants et les bits de résultats du contrôle de parité (P1) de ces mots de code arrivants, suivant une fonction OU-EXCLUSIF (EO1), et que l'on combine les bits de résultats de ces combinaisons aux bits de parité correspondants, qui sont valables pour les parties mémorisées des mots de code à retransmettre, également selon une fonction OU-EXCLUSIF (EO2) pour la détermination de la valeur binaire des bits de parité destinés à la retransmission (figure 3).
